(19) Europäisches Patentamt
European Patent Office
Office européen des brevets

(11) **EP 0 980 140 B1**

(12) **EUROPÄISCHE PATENTSCHRIFT**

(45) Veröffentlichungstag und Bekanntmachung des Hinweises auf die Patenterteilung:
**28.04.2010 Patentblatt 2010/17**

(51) Int Cl.:
***H03K 17/16*** *(2006.01)*

(21) Anmeldenummer: **99115426.1**

(22) Anmeldetag: **04.08.1999**

(54) **Leistungsschaltkreis mit verminderter Störstrahlung**

Power switching circuit with reduced stray radiation

Circuit commutateur de puissance à rayonnement parasite réduit

(84) Benannte Vertragsstaaten:
**DE FR GB IT**

(30) Priorität: **12.08.1998 DE 19836577**

(43) Veröffentlichungstag der Anmeldung:
**16.02.2000 Patentblatt 2000/07**

(73) Patentinhaber: **Infineon Technologies AG**
**81669 München (DE)**

(72) Erfinder: **Horchler, Wolfgang**
**83026 Rosenheim (DE)**

(74) Vertreter: **Bickel, Michael**
**Westphal, Mussgnug & Partner**
**Patentanwälte**
**Herzog-Wilhelm-Strasse 26**
**80331 München (DE)**

(56) Entgegenhaltungen:
**EP-A- 0 684 699    US-A- 5 194 760**
**US-A- 5 687 065**

**Beschreibung**

Die Erfindung betrifft einen Leistungsschaltkreis mit verminderter Störstrahlung, der einen oder mehrere MOS-Leistungstransistoren aufweist.

Mit MOS-Endstufen, die einen Teil von integrierten MOS-Leistungsschaltkreisen wie zum Beispiel Schaltern oder Brückenschaltkreisen bilden, ist es möglich, große Spannungen und Ströme mit sehr kurzen Anstiegszeiten und nahezu idealer Rechteckform zu schalten. Die diese Signale enthaltenden Spektralkomponenten höherer Ordnung wirken jedoch in vielen Fällen als Störstrahlung, die auf benachbarte elektrische oder elektronische Einrichtungen einwirkt und diese in ihrer Funktion beeinträchtigen kann. Die Einsatzmöglichkeit von solchen MOS-Endstufen sind aus diesem Grund mangels ihrer elektromagnetischen Verträglichkeit (EMV) häufig eingeschränkt.

Der Erfindung liegt die Aufgabe zugrunde, einen Leistungsschaltkreis mit verminderter Störstrahlung mit einem oder mehreren MOS-Leistungstransistoren zu schaffen, mit dem bei geringem Schaltungsaufwand eine besonders zuverlässige und wirksame Unterdrückung von Störstrahlungen, insbesondere bei schnellen Schaltvorgängen, möglich ist.

Gelöst wird diese Aufgabe gemäß Anspruch 1 mit einem Leistungsschaltkreis der eingangs genannten Art, der sich dadurch auszeichnet, daß der bzw. mindestens einer der MOS-Leistungstransistoren mit einer Ansteuerschaltung beschaltet ist, die:

> einen Dividierer zur Division der Differenz zwischen einer maximalen Ausgangsspannung (Vs) des MOS-Leistungstransistors und einer momentanen Ausgangsspannung (Vtx) an dem MOS-Leistungstransistor (-Dividend-), durch die maximale Ausgangsspannung (Vs) des MOS-Leistungstransistors (-Divisor-), sowie
> einen Pegelwandler zur Erzeugung einer zu dem ermittelten Quotienten proportionalen Ansteuerspannung (Va) für den MOS-Leistungstransistor aufweist.

Der Erfindung liegt die Erkenntnis zugrunde, daß in MOS-Leistungsschaltkreisen eine besonders wirksame Unterdrückung störender Oberwellenanteile dann möglich ist, wenn die Schaltung "erkennt", wie weit sich die momentane Ausgangsspannung (Vtx bzw. Vout) des betreffenden Leistungstransistors der maximalen Ausgangsspannung (Vs, i.a. die Versorgungsspannung) genähert hat, um die Ansteuerspannung (Va) proportional zu der Differenz zwischen diesen beiden Spannungen zurückzuregeln.

Allerdings ist hierbei nicht die absolute Differenz entscheidend, da zum Beispiel bei gleicher Differenz bei einer hohen maximalen Ausgangsspannung (Vs) die momentane Ausgangsspannung (Vtx bzw. Vout) prozentual näher an der maximalen Ausgangsspannung liegt, als bei einer niedrigeren maximalen Ausgangsspannung. Ein Signal ist also nur dann geeignet, die Ansteuerspannung (Va) eines MOS-Transistors zurückzuregeln, wenn es auf die maximale Ausgangsspannung (Vs) bezogen, d.h. gemäß folgender Formel proportional ist:

$$Va \sim (Vs - Vtx)\ /\ Vs.$$

Im Falle von Gegentakt- und Brückenschaltungen, die mindestens ein Paar von Low-Side- und High-Side-MOS-Leistungstransistoren aufweisen, zwischen die ein Lastwiderstand geschaltet ist, gilt für den / die Low-Side-Transistor(en) folgende Formel {1}:

$$Va \sim a\ (Vs - b\ Vout)\ /\ Vs,$$

wobei "Vout" die Ausgangsspannung am Lastwiderstand ist und die Faktoren "a" und "b" Werte im Bereich von 0,5, 1 oder 2 haben können.

Für den / die High-Side-Transistor(en) gilt mit

$$Vtx = Vs -\quad \text{folgende Formel \{2\}:}$$

$$Va \sim a\ Vout\ /\ b\ Vs,$$

wobei die Faktoren "a" und "b" wiederum die Werte im Bereich von 0,5, 1 oder 2 haben können.

Die in den Ansprüchen 1 und 2 beschriebenen Lösungen machen von dieser Erkenntnis Gebrauch, indem die Gates der MOS-Transistoren definiert geladen und entladen werden, um auf diese Weise "verrundete" Ausgangskennlinien zu erzeugen, mit denen die Oberwellenanteile wesentlich geringer sind.

Die Unteransprüche haben vorteilhafte Weiterbildungen der Erfindung zum Inhalt.

Danach kann der bzw. mindestens einer der High-Side-MOS-Leistungstransistoren mit einer zweiten Ansteuerschaltung beschaltet sein, bei der der Dividierer zur Division einer momentanen Ausgangsspannung (Vout) an dem Lastwiderstand (L) (-Dividend-) durch die maximale Ausgangsspannung (Vs) des MOS-Leistungstransistors (-Divisor-) vorgesehen ist.

Der Dividierer ist vorzugsweise durch ein erstes und ein zweites Element zur Logarithmierung des Dividenden und des Divisors, einen Subtrahierer zur Subtraktion der logarithmierten Werte, sowie einen daran angeschlossenen Pegelwandler mit einem exponentiellen Glied zur Erzeugung des Quotienten ausgeführt.

Dabei kann das erste und das zweite Element jeweils eine erste bzw. eine zweite Diode sein, denen jeweils ein erster bzw. ein zweiter Strom eingeprägt wird, der jeweils proportional zu den zu dividierenden Ausgangsspannungen ist.

Der erste Strom wird dabei vorzugsweise mit einem ersten Widerstand, an dem die Versorgungsspannung (Vs) anliegt, einem zweiten Widerstand, an dem die Ausgangspannung (Vout) anliegt, sowie einer mit diesen Widerständen verbundenen Transistor-Differenzstufe erzeugt, während der zweite Strom mit einem dritten Widerstand erzeugt werden kann, an dem die Versorgungsspannung (Vs) anliegt.

Der Subtrahierer umfaßt vorzugsweise einen Operationsverstärker, an dessen nichtinvertierendem Eingang eine an der ersten Diode abfallende Spannung und an dessen invertierendem Eingang eine an der zweiten Diode abfallende Spannung anliegt.

Weitere Einzelheiten, Merkmale und Vorteile der Erfindung ergeben sich aus der folgenden Beschreibung einer bevorzugten Ausführungsform anhand der Zeichnung. Es zeigt:

> Fig. 1 ein Prinzipschaltbild eines erfindungsgemäßen Leistungsschaltkreises, beschränkt auf die Ansteuerschaltung;
> Fig. 2 ein Gesamtschaltbild eines erfindungsgemäßen MOS-Leistungsschaltkreises mit einer erfindungsgemäßen Ansteuerschaltung und
> Fig. 3 einen Teil der Schaltung gemäß Fig. 2.

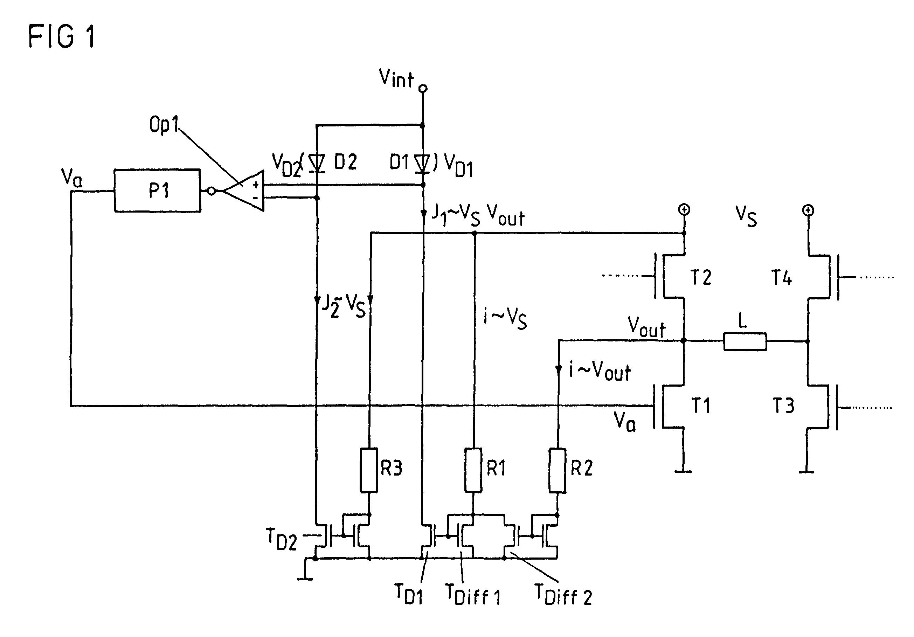

Im rechten Teil des Prinzipschaltbildes gemäß Figur 1 ist eine MOS-Endstufe dargestellt, die durch zwei parallel geschaltete MOS-Leistungstransistor-Paare (Brückenschaltung) gebildet ist. Das erste Paar umfaßt in Reihe geschaltete Low-Side- und High-Side-Transistoren T1, T2, während das zweite Paar durch in Reihe geschaltete Low-Side und High-Side-Transistoren T3, T4 gebildet ist. Zwischen den Paaren liegt ein Lastwiderstand L, während an die High-Side und die Low-Side-Transistoren eine Versorgungsspannung Vs angelegt ist.

Eine erfindungsgemäße Ansteuerschaltung ist nur für den Low-Side-Transistor T1 des ersten Transistorpaares T1, T2 gezeigt. Der Low-Side-Transistor T3 des zweiten Paares kann mit einer gleichen Ansteuerschaltung beschaltet sein. Für die High-Side-Transistoren T2, T4 gilt, daß auch diese jeweils eine erfindungsgemäße Ansteuerschaltung aufweisen können, wobei jedoch die nachfolgend für die Low-Side-Transistoren beschriebene und gemäß obiger Formel {1} erforderliche Differenzbildung der Ströme entfällt (vgl. obige Formel {2}).

Die erfindungsgemäße Ansteuerschaltung umfaßt gemäß Figur 1 eine erste Diode D1, eine zweite Diode D2 und einen Operationsverstärker Op1, an dessen nichtinvertierendem Eingang die Kathode der ersten Diode D1 und an dessen invertierendem Eingang die Kathode der zweiten Diode D2 anliegt. Die Anoden der Dioden D1 und D2 liegen an einem Anschluß Vint an, der zur Zuführung eines Versorgungspotentials zur Einstellung des Arbeitsbereiches der Schaltungskomponenten dient. Der Ausgang des Operationsverstärkers Op1 ist über einen Pegelwandler P1 mit einem exponentiellen Glied zu einem Gateanschluß des Low-Side-MOS-Leistungstransistors T1 geführt.

Eine den MOS-Leistungstransistoren T2 und T4 zugeführte Versorgungsspannung Vs liegt auch an einem ersten Widerstand R1 sowie einem dritten Widerstand R3 an. Die von den MOS-Leistungstransistoren T1 bis T4 erzeugte Ausgangsspannung Vout treibt einen Lastwiderstand L und liegt an einem zweiten Widerstand R2 an. Der über den Widerstand R1, R2 bzw. R3 nach Masse fließende Strom ist jeweils proportional zu der an dem betreffenden Widerstand anliegenden Spannung. Mit einer aus zwei Transistoren TDiff1, TDiff2 bestehenden Transistorstufe wird der über den zweiten Widerstand R2 fließende Strom von dem über den ersten Widerstand R1 fließenden Strom subtrahiert und ein erster Strom I1 erzeugt, der proportional zu der Differenz zwischen der Versorgungsspannung Vs und der momentanen Ausgangsspannung Vout ist. Der über den dritten Widerstand R3 fließende Strom stellt einen zweiten Strom I2 dar.

Der erste Strom I1 wird mittels eines Transistors TD1 der ersten Diode D1 und der zweite Strom I2 mittels eines Transistors TD2 der zweiten Diode D2 eingeprägt. Die über den Dioden D1 und D2 abfallende Spannung VD1 bzw. VD2 ist proportional zu dem Logarithmus des jeweiligen Stroms I1 bzw. I2. Die Spannung VD1. liegt an dem nichtinvertierenden Eingang des Operationsverstärkers Op1 an, während die Spannung VD2 an den invertierenden Eingang des Operationsverstärkers Op1 geführt ist.

Die Ausgangsspannung des Operationsverstärkers Op1 ist somit proportional zu der Differenz der Logarithmen der Ströme I1 und I2. Nach einer Pegelanpassung mit dem Pegelwandler P1, der auch ein exponentielles Glied enthält, liegt an dessen Ausgang eine Ansteuerspannung Va an, die proportional zu dem Quotienten der Ströme I1 und I2 und somit proportional zu der auf die Versorgungsspannung Vs bezogenen Differenz zwischen der Versorgungsspannung Vs und der momentanen Ausgangsspannung Vout ist.

Mit dieser Spannung wird die Ansteuerung der MOS-Endstufe in der Weise zurückgeregelt, daß "verrundete" Ausgangskennlinien entstehen, von denen eine nur noch sehr geringe Störstrahlung ausgeht.

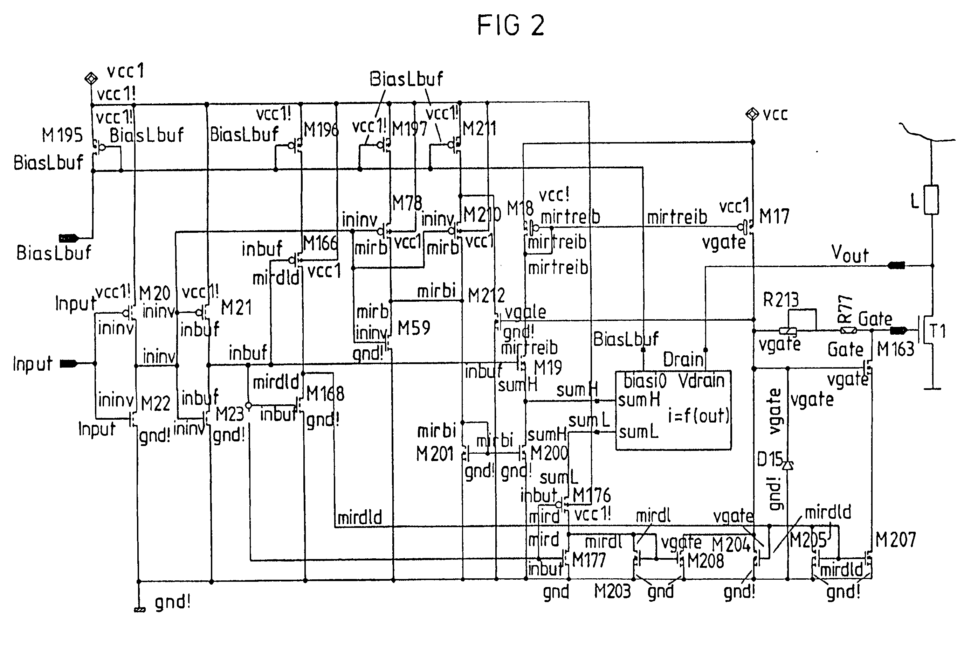

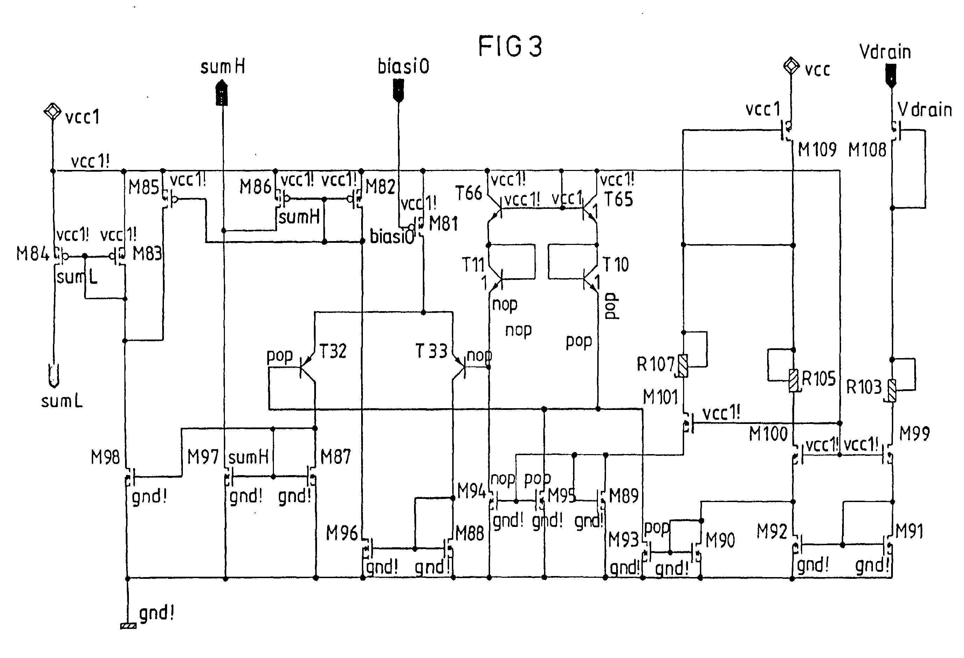

Die Figuren 2 und 3 zeigen ein Gesamtschaltbild eines erfindungsgemäßen MOS-Leistungsschaltkreises, wobei in Figur 3 ein der Figur 1 entsprechender Dividierer dargestellt ist.

Ein wesentliches Teil dieser Schaltung ist der Dividierer, der als gesteuerte Stromquelle i = f (out) arbeitet, über die das Gate des Transistors T1 ge- und entladen wird. Dem Dividierer wird über seinen Anschluß Vdrain die Ausgangsspannung Vout an dem Lastwiderstand L zugeführt. Zur Aufladung des Gates dient der aus zwei Transistoren M17, M18 bestehende Treiber, an dem ein Potential Vcc anliegt und der von zwei Strömen gespeist wird, nämlich dem Drainstrom eines Transistors M200 und dem Strom sumH aus der Dividiererschaltung. Zur Entladung des Gates sind Entladestromsenken vorgesehen, die aus den Stromspiegeln mit Transistoren M205, M206, M207 (Vorentladung), der Stromsenke mit einem Transistor M204 (Gleichstromkomponente) und den Stromspiegeln mit Transistoren M203, M208 (Strom sumL aus der Dividiererschaltung) gebildet sind.

Im Einzelnen weist die Schaltung einen Eingang (input) zur Einspeisung eines Eingangssignals auf. Dieses wird über eine erste Transistorsstufe M20, M22, eine folgende zweite Transistorstufe M21, M23 sowie eine darauf folgende dritte Transistorstufe M166, M168 geführt und gelangt dann zu den Transistoren M204, M205 und M207. Der Transistor M207 ist ausgangsseitig über einen in Reihe geschalteten Transistor M163 mit dem Gate des ersten Transistors T1 verbunden.

Der Ausgang der ersten Stufe liegt auch an einer vierten Transistorsstufe M59, M78 sowie an einer fünften Transistorstufe M210, M201 an, wobei der Gateanschluß des Transistors M201 mit dem Gateanschluß des Transistors M200 verbunden ist. Der Ausgang des Transistors M210 ist mit dein Ausgang des Transistors M212 verbunden, dessen Gate über in Reihe geschaltete Widerstände R213 und R77 an dem Gate des ersten Transistors T1 anliegt.

Der Ausgang der zweiten Stufe ist ferner mit einer sechsten Transistorsstufe M176, M177 verbunden, wobei der Ausgang des Transistors M176 an dem Anschluß sumL der Dividiererschaltung und der Ausgang des Transistors M177 an den Gateanschlüssen der Transistoren M203, M206 anliegt.

Der Ausgang der zweiten Stufe liegt ferner an einem Transistor M19 an, dessen Ausgangsseite an den Anschluß sumH des Dividierers sowie in Reihe mit dem Transistor M200 sowie dem Transistor M18 geschaltet ist.

Die erste bis sechste Transistorstufe ist jeweils durch zwei in Reihe geschaltete Transistoren gebildet, deren Gateanschlüsse jeweils miteinander verbunden sind und den Eingang der betreffenden Stufe darstellen.

Zur Erzeugung und Zuführung von Vorspannungen zu der ersten, zweiten, dritten, vierten und fünften Transistorstufe sowie dem Vorspannungseingang biasO des Dividierers dienen Transistoren M195, M196, M197 und M211, an denen ein Versorgungspotential Vcc1 anliegt.

Der Dividierer i = f (out)) ist im Einzelnen in Figur 3 gezeigt. Im Vergleich zu der in Figur 1 gezeigten Prinzipschaltung entsprechen sich funktional folgende Elemente: die Widerstände R3, R1 und R2 den Widerständen R107, R105 bzw. R103; die Transistoren TDiff1 und TDiff2 den Transistoren M90 bzw. M92; die Transistoren TD1 und TD2 den Transistoren M93 bzw. M94; die Diode D1 den Transistoren T10, T65; die Diode D2 den Transistoren T11, T66; und der Operationsverstärker Op1 den Transistoren T32, T33, die als Differenzstufe geschaltet sind.

Die an dem Lastwiderstand L abgegriffene Spannung liegt an dem Anschluß Vdrain an, der über einen Transistor M108 mit dem Widerstand R103 verbunden ist. Der Widerstand R103 ist über einen Transistor M99 mit einem Transistor M91 verbunden, der an dem Transistor M92 anliegt. Dieser ist mit dem Transistar M90 verbunden, der an dem Transistor M93 anliegt.

Die maximale Ausgangsspannung Vs liegt an dem Anschluß Vcc an, der über einen Transistor M109 mit dem Widerstand R105 sowie dem Widerstand R107 verbunden ist. Der Widerstand R107 liegt an einem Transistor M101, und der Widerstand R105 an einem Transistor M100 an, der wiederum mit dem Transistor M99 verbunden ist. Der Transistor M101 ist mit den Transistoren M89, M95 und M94 verbunden, wobei letzterer zusammen mit dem Transistor T11 an den invertierenden Eingang der Differenzstufe T33/T32 geführt ist. An dem nichtinvertierenden Eingang liegen die Transistoren M93, M95 und T10 an.

Am Ausgang von T32 liegt einerseits über Transistoren M87, M97 der Ausgangsanschluß sumH und andererseits über Transistoren M98, M83 und M84 der Ausgangsanschluß sumL an. Der Ausgang von T33 ist über Transistoren M88, M96, M82 und M86 mit dem Anschluß sumH und über Transistoren M88, M96, M85, M83 und M84 mit dem Anschluß sumL verbunden. Der Anschluß biasO liegt über einem Transistor M81 an den Emittern von T33/T32 an.

Der Dividierer ist schließlich auch mit dem im Zusamenhang mit Figur 2 genannten Versorgungspotential Vcc1 verbunden.

**Patentansprüche**

1. Leistungsschaltkreis mit verminderter Störstrahlung mit mindestens einem MOS-Leistungstransistor, **dadurch gekennzeichnet, daß** der bzw. mindestens einer der MOS-Leistungstransistoren (T1, T2, T3, T4) mit einer Ansteuerschaltung beschaltet ist, die:

   einen Dividierer zur Division der Differenz zwischen einer maximalen Ausgangsspannung (Vs) des MOS-Leistungstransistors und einer momentanen Ausgangsspannung (Vtx) an dem MOS-Leistungstransistor (-Dividend-), durch die maximale Ausgangsspannung (Vs) des MOS-Leistungstransistors (-Divisor-), sowie einen Pegelwandler (P1) zur Erzeugung einer zu dem ermittelten Quotienten proportionalen Ansteuerspannung (Va) für den MOS-Leistungstransistor aufweist.

2. Leistungsschaltkreis nach Anspruch 1, bei dem der mindestens eine MOS-Leistungstransistor ein Low-Side-MOS-Leistungstransistor mindestens eines Paars von Low-Side- und High-Side-MOS-Leistungstransistoren ist, zwischen die ein Lastwiderstand geschaltet ist, wobei die momentane Ausgangsspannung (Vtx) an dem Leistungstransistor über dem Lastwiderstand abfällt.

**3.** Leistungsschaltkreis nach Anspruch 2,
**dadurch gekennzeichnet, daß**
der bzw. mindestens einer der High-Side-MOS-Leistungstransistoren (T2, T4) mit einer zweiten Ansteuerschaltung beschaltet ist, bei der:

der Dividierer zur Division einer momentanen Ausgangsspannung (Vout) an dem Lastwiderstand (L) (-Dividend-) durch die maximale Ausgangsspannung (Vs) des MOS-Leistungstransistors (-Divisor-) vorgesehen ist.

**4.** Leistungsschaltkreis nach einem der vorhergehenden Ansprüche,
**dadurch gekennzeichnet, daß**
der Dividierer ein erstes und ein zweites Element (D1, D2) zur Logarithmierung des Dividenden und des Divisors, einen Subtrahierer (Op1) zur Subtraktion der logarithmierten Werte, sowie einen daran angeschlossenen Pegelwandler (P1) mit einem exponentiellen Glied zur Erzeugung des Quotienten aufweist.

**5.** Leistungsschaltkreis nach Anspruch 4,
**dadurch gekennzeichnet, daß**
das erste und das zweite Element jeweils eine erste bzw. eine zweite Diode (D1, D2) ist, denen jeweils ein erster bzw. ein zweiter Strom (I1, I2) eingeprägt wird, der jeweils proportional zu den zu dividierenden Ausgangsspannungen ist.

**6.** Leistungsschaltkreis nach Anspruch 5,
**dadurch gekennzeichnet, daß**
der erste Strom (I1) mit einem ersten Widerstand (R1), an dem die Versorgungsspannung (Vs) anliegt, einem zweiten Widerstand (R2), an dem die Ausgangsspannung (Vout) anliegt, sowie einer mit diesen Widerständen verbundenen Transistor-Differenzstufe (TDiff1, TDiff2) erzeugt wird.

**7.** Leistungsschaltkreis nach Anspruch 5 oder 6,
**dadurch gekennzeichnet, daß**
der zweite Strom (I2) mit einem dritten Widerstand (R3) erzeugt wird, an dem die Versorgungsspannung (Vs) anliegt.

**8.** Leistungsschaltkreis nach einem der Ansprüche 4 bis 7,
**dadurch gekennzeichnet, daß**
der Subtrahierer einen Operationsverstärker (Op1) aufweist, an dessen nichtinvertierendem Eingang eine an der ersten Diode (D1) abfallende Spannung und an dessen invertierendem Eingang eine an der zweiten Diode (D2) abfallende Spannung anliegt.

**9.** Leistungsschaltkreis nach einem der vorhergehenden Ansprüche,
**dadurch gekennzeichnet, daß**
die maximale Ausgangsspannung (Vs) eine Versorgungsspannung ist.

**10.** Leistungsschaltkreis nach einem der vorhergehenden Ansprüche,
**dadurch gekennzeichnet, daß**
der Dividend die Differenz zwischen der maximalen Ausgangsspannung (Vs) und der momentanen, mit einem vorbestimmten Faktor multiplizierten Ausgangsspannung (Vout) ist.

**11.** Leistungsschaltkreis nach Anspruch 10,
**dadurch gekennzeichnet, daß**
der Faktor den Wert 0,5, 1 oder 2 hat.

## Claims

**1.** Power switching circuit with reduced interference radiation having at least one MOS power transistor,
**characterized in that**
the or at least one of the MOS power transistors (T1, T2, T3, T4) is connected up to a drive circuit having:

a divider for dividing the difference between a maximum output voltage (Vs) of the MOS power transistor and an instantaneous output voltage (Vtx) at the MOS power transistor (-dividend-) by the maximum output voltage (Vs) of the MOS power transistor (-divisor-), and also a level converter (P1) for generating a drive voltage (Va) for the MOS power transistor, said drive voltage being proportional to the quotient determined.

**2.** Power switching circuit according to Claim 1, in which the at least one MOS power transistor is a low-side MOS power transistor of at least one pair of low-side and high-side MOS power transistors between which a load resistor is connected, the instantaneous output voltage (Vtx) at the power transistor being dropped across the load resistor.

**3.** Power switching circuit according to Claim 2,
**characterized in that**
the or at least one of the high-side MOS power transistors (T2, T4) is connected up to a second drive circuit in which:

the divider is provided for dividing an instantaneous output voltage (Vout) at the load resistor (L) (-dividend-) by the maximum output voltage (Vs) of the MOS power transistor (-divisor-).

4. Power switching circuit according to one of the preceding claims,
 **characterized in that**
 the divider has a first and a second element (D1, D2) for logarithmizing the dividend and the divisor, a subtractor (OP1) for subtracting the logarithmized values, and also a level converter (P1), connected thereto with an exponential element for generating the quotient.

5. Power switching circuit according to Claim 4,
 **characterized in that**
 the first and the second element is respectively a first and a second diode (D1, D2), on which is respectively impressed a first and a second current (I1, I2), which is in each case proportional to the output voltages to be divided.

6. Power switching circuit according to Claim 5,
 **characterized in that**
 the first current (I1) is generated by means of a first resistor (R1), to which the supply voltage (Vs) is applied, a second resistor (R2), to which the output voltage (Vout) is applied, and also a transistor differential stage (TDiff1, TDiff2) connected to these resistors.

7. Power switching circuit according to Claim 5 or 6,
 **characterized in that**
 the second current (I2) is generated by means of a third resistor (R3), to which the supply voltage (Vs) is applied.

8. Power switching circuit according to one of Claims 4 to 7,
 **characterized in that**
 the subtractor has an operational amplifier (Op1), to whose non-inverting input a voltage dropped across the first diode (D1) is applied and to whose inverting input a voltage dropped across the second diode (D2) is applied.

9. Power switching circuit according to one of the preceding claims,
 **characterized in that**
 the maximum output voltage (Vs) is a supply voltage.

10. Power switching circuit according to one of the preceding claims,
 **characterized in that**
 the dividend is the difference between the maximum output voltage (Vs) and the instantaneous output voltage (Vout) multiplied by a predetermined factor.

11. Power switching circuit according to Claim 10,
 **characterized in that**
 the factor has the value 0.5, 1 or 2.

**Revendications**

1. Circuit commutateur de puissance à rayonnement parasite réduit, comprenant au moins un transistor de puissance MOS,
 **caractérisé en ce que**
 le ou au moins l'un des transistors (T1, T2, T3, T4) de puissance MOS est branché avec un circuit de commande, qui a :

 un élément de division, pour la division de la différence entre une tension (Vs) de sortie maximum du transistor de puissance MOS et une tension (Vtx) de sortie instantanée sur le transistor de puissance MOS (-dividende-) par la tension (Vs) de sortie maximum du transistor de puissance MOS (-diviseur-), ainsi que
 un convertisseur (P1) de niveau, pour la production d'une tension (Va) de commande du transistor de puissance MOS proportionnelle au quotient déterminé.

2. Circuit commutateur de puissance suivant la revendication 1, dans lequel le au moins un transistor de puissance MOS est un transistor MOS low-side d'au moins une paire de transistors de puissance MOS low-side et high-side, entre lesquels est montée une résistance de charge, à la tension (Vtx) de sortie instantanée chutant aux bornes du transistor de puissance dans la résistance de charge.

3. Circuit commutateur de puissance suivant la revendication 2,
 **caractérisé en ce que**
 le ou au moins l'un des transistors (T2, T4) de puissance MOS high-side est branché avec un deuxième circuit de commande, dans lequel :

 l'élément de division est prévu pour la division d'une tension (Vout) de sortie instantanée sur la résistance (L) de charge (-dividende-) par la tension (Vs) de sortie maximum du transistor de puissance MOS (-diviseur-).

4. Circuit commutateur de puissance suivant l'une des revendications précédentes,
 **caractérisé en ce que**
 l'élément de division a un premier et un deuxième éléments (D1, D2) pour la mise en logarithme du dividende et du diviseur, un élément soustracteur (Op1) pour la soustraction des valeurs mises en logarithme, ainsi qu'un convertisseur (P1) de niveau qui y est raccordé et qui comprend un organe exponentiel pour la production du quotient.

5. Circuit commutateur de puissance suivant la revendication 4,
   **caractérisé en ce que**
   le premier et le deuxième éléments sont respectivement une première et une deuxième diodes (D1, D2), auxquelles sont injectés respectivement un premier et un deuxième courants (I1, I2), chaque courant étant respectivement proportionnel aux tensions de sortie à diviser.

6. Circuit commutateur de puissance suivant la revendication 5,
   **caractérisé en ce que**
   le premier courant (I1) est produit par une première résistance (R1), à laquelle s'applique la tension (Vs) d'alimentation, par une deuxième résistance (R2), à laquelle s'applique la tension (Vout) de sortie, ainsi que par un étage (TDiff1, TDiff2) différentiel de transistor relié à ces résistances.

7. Circuit commutateur de puissance suivant la revendication 5 ou 6,
   **caractérisé en ce que**
   le deuxième courant (I2) est produit par une troisième résistance (R3) à laquelle s'applique la tension (Vs) d'alimentation.

8. Circuit commutateur de puissance suivant l'une des revendications 4 à 7,
   **caractérisé en ce que**
   l'élément de soustraction a un amplificateur opérationnel (Op1) à l'entrée non inverseuse duquel s'applique une tension chutant aux bornes de la première diode (D1) et à l'entrée inverseuse duquel s'applique une tension chutant aux bornes de la deuxième diode (D2).

9. Circuit commutateur de puissance suivant l'une des revendications précédentes,
   **caractérisé en ce que**
   la tension (Vs) de sortie maximum est une tension d'alimentation.

10. Circuit commutateur de puissance suivant l'une des revendications précédentes,
    **caractérisé en ce que**
    le dividende est la différence entre la tension (Vs) de sortie maximum et la tension (Vout) de sortie instantanée multipliée par un facteur déterminé à l'avance.

11. Circuit commutateur de puissance suivant la revendication 10,
    **caractérisé en ce que**
    le facteur a la valeur 0,5, 1 ou 2.

FIG 1

EP 0 980 140 B1

FIG 2

FIG 3

EP 0 980 140 B1